# EUROPEAN PATENT APPLICATION

(11) **EP 1 662 655 A1**
(43) Date of publication of application: **31.05.2006**
(21) Application number: 04292803.6
(22) Date of filing: 26.11.2004
(51) Int. Cl.: H03F 1/32

(54) **Power amplifier with digital linearisation device**

(71) Applicant: ALCATEL, 75008 Paris (FR)
(72) Inventor: Pascht, Andreas, 73635 Rudersberg (DE); Bitzer, Thomas, 73614 Schorndorf (DE); Bohn, Thomas, 70176 Stuttgart (DE)
(74) Representative: Schäfer, Wolfgang

(57) **Abstract**

A power amplifier (20) comprising at least two non-linear amplifier stages (13,23) and two digital linearisation devices (11,21) is arranged in such a way that a first digital linearisation device (11) and a first non-linear amplifier stage (13) form an inner compensation loop, which compensates for non-linear distortions generated by the first amplifier stage, while the second digital linearisation device (21), the inner compensation loop (11,13) and the second amplifier stage (23) form an outer compensation loop. Since the inner compensation loop provides ideally a linear transfer function, the outer compensation loop compensates only for non-linear distortions generated by the second amplifier stage.

## Description

The invention relates to an electric power amplifier in particular for a base station of a mobile communication system.

It is known to use a power amplifier for example in a base station of a mobile communication system. It is also known that this amplifier often comprises a number of amplification elements wherein each one of these amplification elements usually has non-linear characteristics. All these non-linear characteristics taken together constitute a very complex non-linear transfer function of the amplifier.

In order to compensate these non-linearities, it is known to use a digital linearisation device. For that purpose, the output of the amplifier is coupled to the digital linearisation device via an analogue-to-digital converter. The digital linearisation device builds up a transfer function that is inverse to the transfer function of the amplifier. The output of the digital linearisation device is then forwarded to the amplifier via a digital-to-analogue converter.

Due to the complex transfer function of the amplifier, the digital linearisation device is also very complex and difficult to be realized.

It is an object of the invention to provide an electric power amplifier that is less complex to be realized.

The invention solves this object by an electric power amplifier comprising at least two electric non-linear amplification elements and at least two digital linearisation devices, wherein each one of the two digital linearisation devices is assigned to only one of the two non-linear amplification elements.

According to the invention, the linearisation of each one of the non-linear amplification elements is carried out separately. For that purpose, a respective digital linearisation device is assigned to each one of the non-linear amplification elements. As a result, each one of the digital linearisation devices only has to compensate one single non-linear amplification element. The transfer function of one single non-linear amplification element, however, is less complex than the transfer function of a number of non-linear amplification elements. Therefore, less efforts are necessary to compensate this transfer function of one single non-linear amplification element by an inverse transfer function of the corresponding digital linearisation device.

As a result, it is easier to realize the power amplifier according to the invention, in particular the digital linearisation devices of the power amplifier. Furthermore, the power amplifier according to the invention is able to work more effectively, in particular more power can be provided with less efforts. It is therefore possible that less amplification elements are necessary for the power amplifier according to the invention compared to known power amplifiers.

The afore-mentioned advantages furthermore result in less cooling requirements and a smaller size of the power amplifier according to the invention.

Further features, applications and advantages of the invention will become apparent from the following description of exemplary embodiments of the invention which are shown in the drawings. All described and shown features themselves or in any combination represent the subject matter of the invention, independently of their wording in the description or their representation in the drawings and independently of their combination in the claims or the dependencies of the claims.

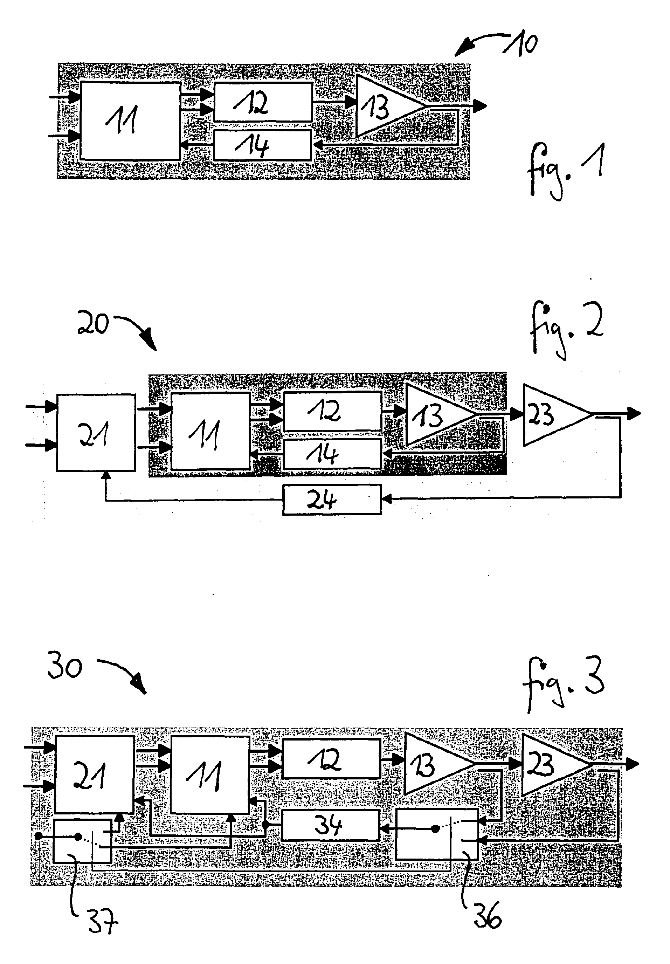

Figure 1 shows a schematic block diagram of a first embodiment of an electronic power amplifier, figure 2 shows a schematic block diagram of a second embodiment of an electronic power amplifier according to the invention, and figure 3 shows a schematic block diagram of a third embodiment of an electronic power amplifier according to the invention.

In figures 1 to 3, power amplifiers 10, 20, 30 are shown that may be used for amplifying the power for example within a base station of a mobile communication system.

The power amplifier 10 of figure 1 comprises a digital linearisation device 11, a digital-to-analogue converting device 12, an amplification device 13 and an analogue-to-digital converting device 14. The digital-to-analogue converting device 12 and the analogue-to-digital converting device 14 may comprise mixing circuits or other additional circuits, respectively. Furthermore, it is assumed that the digital-to-analogue converting device 12 and the analogue-to-digital converting device 14 only comprise linear electric elements.

The output of the amplification device 13 is provided with a coupling device for coupling out a small part of the output signal of the amplification device 13. With the help of this coupling device, a feedback path is built up from the amplification device 13 via the analogue-to-digital converting device 14 to the digital linearisation device 11.

The output/s of the digital linearisation device 11 is/are provided via the digital-to-analogue converting device 12 to the input of the amplification device 13. In addition to the input from the analogue-to-digital converting device 14, the digital linearisation device 11 may also have further inputs from other devices.

The amplification device 13 of figure 1 does only comprise one single electric non-linear amplification element, for example one single transistor. It is assumed that all other elements of the amplification device 13 are linear electric elements.

The digital linearisation device 11 of figure 1 is adapted to correct the non-linearities of the single non-linear amplification element comprised in the amplification device 13.

As an example, the linearisation of the digital linearisation device 11 is carried out with the help of a digital pre-distortion that builds up a transfer function which is inverse to the transfer function of the amplification device 13, i.e. to the transfer function of the single non-linear amplification element comprised in the amplification device 13.

As outlined, the power amplifier 10 of figure 1 only comprises one amplification element. If more amplification elements are necessary to reach the required power, the power amplifiers 20, 30 of figures 2 and 3 have to be used.

The power amplifier 20 of figure 2 comprises the digital linearisation device 11, the digital-to-analogue converting device 12, the amplification device 13 and the analogue-to-digital converting device 14 of figure 1. Insofar, reference is made to the above description of figure 1.

In addition, the output of the amplification device 13 is fed into a second amplification device 23. The output of this second amplification device 23 is provided with a coupling device for coupling out a small part of the output signal of the second amplification device 23. With the help of this coupling device, a feedback path is built up from the second amplification device 23 via a second analogue-to-digital converting device 24 to a second digital linearisation device 21.

The second analogue-to-digital converting device 24 may comprise mixing circuits or other additional circuits. Furthermore, it is assumed that the second analogue-to-digital converting device 24 only comprises linear electric elements.

The output/s of the second digital linearisation device 21 is/are input to the first digital linearisation device 11. In addition to the input from the second analogue-to-digital converting device 24, the second digital linearisation device 21 may also have further inputs from other devices.

As already outlined, the first amplification device 13 does only comprise one single electric non-linear amplification element, for example one single transistor. Furthermore, the first digital linearisation device 11 is adapted to correct the non-linearities of the single non-linear amplification element comprised in the first amplification device 13.

Similarly, the second amplification device 23 of figure 2 does only comprise one single electric non-linear amplification element, for example one single transistor. The second digital linearisation device 21 of figure 2 is adapted to correct the non-linearities of the single non-linear amplification element comprised in the amplification device 23.

As an example, the linearisation of the second digital linearisation device 21 is carried out with the help of a digital pre-distortion that builds up a transfer function which is inverse to the transfer function of the second amplification device 23, i.e. to the transfer function of the single non-linear amplification element comprised in the second amplification device 23.

As a result, the linearisation of the power amplifier 20 is carried out separately. Each one of the two digital linearisation devices 11, 21 is assigned to only one of the two amplification devices 13, 23, i.e. to only one of the two non-linear amplification elements comprised in these amplification devices 13, 23.

The linearisation of the first amplification device 13 is carried out by the first digital linearisation device 11 and the linearisation of the second amplification device 23 is carried out by the second digital linearisation device 21. The first digital linearisation device 11, therefore, is adapted to the single non-linear amplification element comprised in the first amplification device 13 and the second digital linearisation device 21 is adapted to the single non-linear amplification element comprised in the second amplification device 23.

This means in other words that it is not necessary to adapt one of the digital linearisation devices 11, 21 to more than one non-linear amplification element. Instead, any of the digital linearisation devices 11, 21 must only be adapted to one non-linear amplification element. This allows an optimisation of the digital linearisation devices 11, 21 to the respective non-linear amplification element.

It is apparent that further amplification devices may be added to the power amplifier 20 of figure 2 in the same manner as the second amplification device 23 was added in figure 2. In this case, all amplification devices, i.e. all non-linear amplification elements of these amplification devices build up an amplification chain. For any additional amplification device, respective digital linearisation devices and analogue-to-digital converting devices also have to be added. Each one of the number of digital linearisation devices is thereby assigned to only one of the same number of amplification devices. By adding the afore-mentioned devices, the amplification of the power amplifier 20 may be increased.

The power amplifier 30 of figure 3 corresponds to the power amplifier 20 of figure 2. Identical features therefore carry identical reference numerals. With regard to such identical features, reference is made to figure 2.

In contrast to figure 2, the power amplifier of figure 3 only comprises one analogue-to-digital converting device 34. This results in only one feedback path that is shared by both amplification devices 13, 23. As a precondition of the single analogue-to-digital converting device 34, the two amplification devices 13, 23 must have identical or at least similar characteristics, in particular with regard to their frequency-dependant amplification behaviour. Furthermore, one or more attenuation devices may be necessary to ensure that the signals coupled out from the output of the amplification devices 13, 23 and forwarded to the first switch 36, have an identical or at least similar level. These attenuation devices may be comprised in the coupling devices and/or in the first switch 36.

In figure 3, a first switch 36 is provided between the two amplification devices 13, 23 and the analogue-to-digital converting device 34. The output of the analogue-to-digital converting device 34 is coupled to both digital linearisation devices 11, 21. Furthermore, a second switch 37 is provided which is coupled with the first switch and which forwards an enable-signal to only one of the two digital linearisation devices 11, 21.

With the help of the two switches 36, 37, a corresponding pair of an amplification device and a digital linearisation device are assigned to each other. For example, the output of the first amplification device 13 is forwarded via the first switch 36 to the single analogue-to-digital converting device 34 wherein at the same time, the first digital linearisation device 11 is enabled by the second switch 37. This situation is shown in figure 3. The same function can also be carried out in connection with the second amplification device 23 and the second digital linearisation device 21.

As the digital linearisation devices 11, 21 usually have a relatively low update rate, a subsequent update of these digital linearisation devices 11, 21 is possible. As described, this update function can be realized with the help of the two switches 36, 37.

Similarly as in figure 2, the linearisation of the power amplifier 30 of figure 3 is carried out separately. Again, each one of the two digital linearisation devices 11, 21 is assigned to only one of the two amplification devices 13, 23, i.e. to only one of the two non-linear amplification elements comprised in these amplification devices 13, 23.

As a result, the first digital linearisation device 11 is adapted to the single non-linear amplification element comprised in the first amplification device 13 and the second digital linearisation device 21 is adapted to the single non-linear amplification element comprised in the second amplification device 23. This means in other words that each one of the digital linearisation devices 11, 21 must only be adapted to one non-linear amplification element. This allows an optimisation of the digital linearisation devices 11, 21 to the respective non-linear amplification element.

It is apparent again that further amplification devices may be added to the power amplifier 30 of figure 3 so that an amplification chain is built up. The output of any additional amplification device must be connected to the first switch 36. Furthermore, corresponding additional digital linearisation devices have to be added. These additional digital linearisation devices have to be coupled to the second switch 37 and thereby to the enable-signal. Each one of the number of digital linearisation devices is thereby assigned to only one of the same number of amplification devices. By adding the afore-mentioned devices, the amplification of the power amplifier 30 may be increased.

In the above description, the amplification devices 13, 23 of the power amplifiers 20, 30 of figures 2, 3 only comprise one single non-linear amplification element. It has to be mentioned that it is possible that the described power amplifiers 20, 30 additionally comprise an amplification device with more than one non-linear amplification element. For example, the power amplifiers 20, 30 of figures 2, 3 may comprise three amplification devices, i.e. the two described amplification devices 13, 23 and an additional amplification device, wherein the described amplification devices 13, 23 only comprise one single non-linear amplification element, respectively, whereas the additional amplification device comprises more than one non-linear amplification element. In this case, the described advantages are still present with regard to the described amplification devices 13, 23.

The described embodiments of the invention may not only be used in connection with a mobile communication system, but also in connection with other kinds of communication systems. Even more, the described invention may be used in any electrical system that comprises several non-linear amplification elements being connected in series.

## Claims

1. An electric power amplifier (20, 30) in particular for a base station of a mobile communication system, comprising at least two electric non-linear amplification elements and at least two digital linearisation devices (11, 21), wherein each one of the two digital linearisation devices (11, 21) is assigned to only one of the two non-linear amplification elements.

2. The amplifier (20, 30) of claim 1, wherein each one of the digital linearisation devices (11, 21) carries out a pre-distortion with regard to the corresponding non-linear amplification element.

3. The amplifier (20, 30) of one of claims 1 or 2, wherein each one of the digital linearisation devices (11, 21) builds up a transfer function that is inverse to the transfer function of the corresponding non-linear amplification element.

4. The amplifier (20) of one of claims 1 to 3, wherein each one of the non-linear amplification elements is connected to its corresponding digital linearisataion device (11, 21) via a corresponding analogue-to-digital converting device (14, 24).

5. The amplifier (30) of one of claims 1 to 3, wherein the non-linear amplification elements are coupled to the digital linearisation devices (11, 21) via a single analogue-to-digital converting device (34), and wherein two switches (36, 37) are provided for assigning a corresponding pair of a non-linear amplification element and a digital linearisation device (11, 21).

6. The amplifier (20, 30) of one of claims 1 to 5, wherein the non-linear amplification elements are fed from a digital-to-analogue converting device (12).

7. The amplifier (20, 30) of one of claims 1 to 6, wherein the non-linear amplification elements represent an amplification chain.

8. The amplifier (20, 30) of one of claims 1 to 7, wherein the non-linear amplification elements are comprised in respective amplification devices (13, 23).
